# EUROPÄISCHE PATENTSCHRIFT

(11) **EP 1 345 252 B1**
(45) Veröffentlichungstag und Bekanntmachung des Hinweises auf die Patenterteilung: **07.03.2007**
(21) Anmeldenummer: 03001509.3
(22) Anmeldetag: 23.01.2003
(51) Int. Cl.: H01L 21/00

(54) **Lagerung eines Substrathalterrades mit darin eingebautem/verankertem Substrathalter**
Mounting part of a wheel of a substrate holder with built in/anchored substrate holder
Element de montage de roue d'un porte-substrat avec un porte-pièce integree/anchre

(30) Priorität: 16.03.2002 DE 10211827
(43) Veröffentlichungstag der Anmeldung: 17.09.2003
(73) Patentinhaber: Forschungszentrum Karlsruhe GmbH, 76133 Karlsruhe (DE)
(72) Erfinder: Ratzel, Fritz, 76351 Linkenheim (DE); Geerk, Jochen, Dr., 76356 Weingarten (DE)

(56) Entgegenhaltungen:
- WO-A-02/02841
- DE-C- 19 932 338

## Beschreibung

Die Erfindung betrifft die Lagerung eines Substrathalterrades mit darin eingebautem/verankertem Substrathalter in einer Anlage zur Beschichtung eines eingespannten und beheizbaren Substrats. Ein solches befindet sich zur Beschichtung mit einem Hochtemperatursupraleitermaterial oder sonstigen keramischen Materialien in einer Heizzone, in der es gleichzeitig von einem Materialstrom aus ebensolchen Materialien ein- oder beidseitig angeströmt wird. Der Materialstrom kommt meist von einer Sputterquelle, häufig eine Zylinderkathode oder sonstige Plasmaquellen, her. Um auf der oder den exponierten Seiten des im Substrathalter eingespannten Substrats eine Materialschicht gleichmäßiger Schichtdicke abzulegen, rotiert der Substrathalter um seine Drehachse in der Heizzone. Dass die Materialdeponierung auf dem Substrat in einer solchen Heizzone durchgeführt wird, hängt von den vorgegebenen und damit einzustellenden Eigenschaften der abgelegten Dünnschicht ab.

In der DE 199 32 338 wird eine Vorrichtung zum Rotieren eines mit keramischen und metallischen Substanzen zu beschichtenden Substrats beschrieben. Die Vorrichtung besteht aus zwei gleichen, konzentrisch zueinander liegenden Ringscheiben aus mindestens bis zur höchsten Betriebstemperatur formstabilem, chemisch inertem Material, die über Distanzhalter zueinander auf Abstand gehalten sind. In den Ringscheiben ist jeweils eine konzentrische Ringnut mit v-förmigem Querschnitt. Die beiden Ringnuten liegen einander gegenüber. In einem ringförmigen Substrathalter aus mindestens bis zur höchsten Betriebstemperatur formstabilem, chemisch inertem Material ist an seinen beiden Stirnseiten je eine gleichartige Ringnut wie in den Ringscheiben eingelassen. Auf der Mantelfläche des Substrathalters ist ein Zahnkranz. Die Vorrichtung besteht mit aus Kugeln aus einem mindestens bis zur höchsten Betriebstemperatur formstabilem, abriebfestem und chemisch inertem Material, die schlecht wärmeleitend sind. Sie rollen in den einander gegenüberliegenden, ein Laufbett bildenden Ringnuten. Jede Kugel berührt die jeweilige Ringnut höchstens an zwei Punkten. Weiter hat die Vorrichtung einen an den beiden Ringscheiben angebrachten Lagerbock, in dem eine von der Umgebungstemperatur bis zur höchsten Betriebstemperatur belastbare Antriebswelle endet. Auf dieser sitzt eine Getriebeschnecke auf, die über eine Distanzhülse im Bereich des Lagerbocks derart in Position gehalten wird, daß sie in den Zahnkranz eingreift. Mit einem an den Ringscheiben befestigten Haltearm, wird die Vorrichtung senkrecht zu der Drehachse des Substrathalters bewegt. Die Heizung ist ein u-förmiges Heizblech zwischen dem ein zu beschichtendes Substrat bei eingestellter Temperatur exponiert ist und über je einen Durchbruch in den beiden Schenkel von dem in der jeweiligen Quelle freigesetzten Materialstrom angeströmt wird.

In der DE 100 32 005 (WO 02/02841) wird ein Waferhalterad mit Andrückvorrichtung in einer Waferbeschichtungsanlage beschrieben. Es besteht aus einem Halterad mit einem Zahnkranz und einer v-förmigen Nut um die äußere Mantelfläche. Das Waferhalterad mit Andrückvorrichtung hat ein konzentrisch am Halterad angeschraubtes kreisringförmiges Trägerblech, an dessen inneren Kreis gleichverteilt mindestens drei Haltestäbchen montiert sind. Die Haltestäbchen haben an ihrer freien Stirn eine Nut. Mindestens zwei Haltestäbchen oder die Haltestäbchen sind innerhalb eines Winkels kleiner als 180° starr und die übrigen in der Ebene des Trägerblechs schwenkbar montiert. Dadurch wird die stirnseitig zu beschichtende, kreisförmig Substratscheibe stets zentriert in die jeweilige Stirnnut der starren Haltestäbchen eingelegt und wird mit den dann radial ausgerichteten Haltestäbchen in Position gehalten. Die Andrückvorrichtung besteht aus mindestens drei Rollen, die in der v-förmigen Nut am Umfang des Zahnkranzes abrollen. Eine der Rollen ist auf einem einarmigen Hebel montiert ist, der an seinem einen Ende am Rahmen der Andrückvorrichtung drehbar gelagert ist. Dadurch kann diese Rolle auf das Halterad zu oder von ihm weggeschwenkt werden. Diese Rolle liegt den übrigen Rollen, die innerhalb eines Winkels von < 180° vom Mittelpunkt des Halterades aus fest am Rahmen montiert sind, gegenüber. Die Andrückvorrichtung hat einen weiteren, am Rahmen drehbar gelagerten, zweiarmigen Hebel, der mit seinem einen freien Ende unter das freie des einarmigen Hebels greift und an seinem andern Ende ein Gewicht vorgegebener Gewichtskraft hängen hat oder eine am Rahmen eingehängte Zugfeder vorgegebener Federkonstanten ebenfalls eingehängt hat. Dadurch drückt die schwenkbare Rolle stets mit vorgegeben beschränkter Kraft gegen das Waferrad. Weiter besteht sie aus einem Antriebsrad mit kleinem Radius und Zahnkranz auf der Mantelfläche und einem Zahnkranz mit großem Radius am Rande einer Stirnfläche des Antriebsrads, in den ein über eine Welle an deren distalem Ende sitzendes, von außen angetriebenes Kegelzahnrad eingreift.

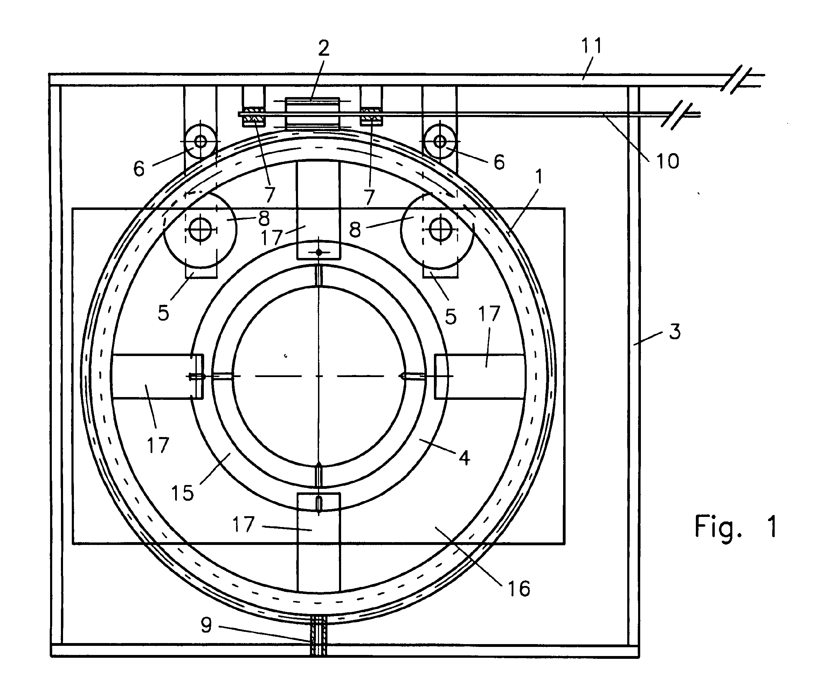

In der DE 100 37 566.9 wird eine Substratheizung zum gleichzeitig beidseitigen Beheizen eines Wafers vorgestellt. Eine solche Heizeinrichtung wird dort in einer Multikammeranlage, dem "Lindwurm", eingesetzt. Mit dieser Heizeinrichtung wird eine in der Figur 1 durch ein Rechteck angedeutete Heizfläche/-zone erreicht. Im Heizzwischenraum bestehen beim Prozeß hohe Temperaturen etwa bis zur Rotglut der dort exponierten metallischen Gegenstände, also im Bereich von etwa 800°C. Eine durch eine solche Heizzone drehender Rotationseinrichtung zum Drehen eines darin exponierten Substrats ist erheblichen thermischen Belastungen ausgesetzt, die zu Verformungen führen. Das führt bei Nichtbeachtung zur Entkopplung im Antriebsmechanismus oder zu Blockierungen und damit zu im Allgemeinen ausschüssigen Substratbeschichtungen.

Es wurde aufgrund solcher Fehlfunktionen die Aufgabe gestellt, eine Vorrichtung zum Drehen eines Substrats bereitzustellen, mit der dieses auch bei hohen Temperaturen, allen möglichen Prozesstemperaturen, zuverlässig in einem Prozessraum gedreht/angetrieben wird.

Die Aufgabe wird durch die Lagerung eines Schneckenrads mit Substrathalter in einer solchen Anlage zur Beschichtung eines eingespannten und beheizbaren Substrats gemäß den Merkmalen des Anspruchs 1 gelöst.

Bei den thermisch extremen Unterschieden/Bedingungen ist die Lagerung des Schneckenrads und des darin eingebaute Substrathalters von maßgebender Bedeutung einerseits für die zuverlässige Rotation durch thermisch stark verschiedene Bereiche und zerstörungsfreies Halten während des Beschichtungsprozesses. Letzteres ist für die Beschränkung des Ausschusses auf ein Minimum von großer Bedeutung.

Die Verankerung dieses Antriebsprinzips besteht aus einer Hubstange, an der ein Trägerrahmen hängend festgemacht ist. Zwei an der Hubstange hängend befestigte, zu derselben fluchtende Lagerböcken, ragen in den von der Hubstange und dem Trägerrahmen umspannten Innenbereich und stehen auf Abstand zueinander.

Am Ende einer Antriebsstange, die an ihrem Anfang in einen weit außerhalb der Prozesszone sitzenden Antriebsmotor eingespannt ist - dieser kann auch ganz außerhalb des Prozessraums sitzen, so dass die Antriebsstange durch eine Durchführung ragt - sitzt die Schnecke, die in den seitlichen oder umfangsseitigen Zahnkranz des Schneckenrades eingreift. Das ist der aus dem Stande der Technik bekannte Antriebsaufbau, der Schneckenantrieb.

Je zwei Lagerrollen aus hochwärmefestem, sehr schlecht die Wärme leitendem, dielektrischem Material, wie Oxidkeramik, sind im Endbereich der beiden Lagerböcke drehbar gelagert und drehen in einer gemeinsamen Drehebene. Das darauf eingehängte Schneckenrad wird von zwei Gegenlagerrollen aus ebenfalls hochwärmefestem, sehr schlecht die Wärme leitendem, dielektrischen Material mit zulässigem Spiel in der Lage gehalten, so dass es nicht herausspringen kann. Diese Gegenlagerrollen sind ebenfalls an die beiden Lagerböcke angebaut und drehen gegebenenfalls in der gleichen Ebene wie die beiden Lagerrollen.

Ein Rollenlager aus zwei zylindrischen Lagerrollen aus wie oben dielektrischem Material steht im Bodenteil des Trägerrahmens dies- und jenseits unter Abstand von mindestens der Dicke des Schneckenrads. Zwischen diesen beiden läuft das Schneckenrad hängend mit wenig Seitenspiel durch und wird so geführt, so dass das Schneckenrad allenfalls in diesem Lagerspalt pendeln kann.

Die zwischen den zwei kleinen Lagerböcken drehende Schnecke sitzt auf der Antriebsstange, die in den Lagerhülsen gleitend dreht. Die Lagerhülse ist aus dem oben charakterisierten dielektrischen Material, der Oxidkeramik. Beide Lagerhülsen sitzen fluchtend zueinander und parallel zu der Drehebene. Aufgrund der Wärmesituation im Prozessraum greift die Schnecke mit Spiel in den Zahnkranz des Schneckenrads ein. Die Zahnhöhe ist an beiden Getriebekomponenten so hoch, dass bei jeder Prozesstemperatur stets ein sicheres, mit Spiel verbundenes Ineinandergreifen besteht.

Die Achse des Substrats muss nicht mit der Drehachse zusammenfallen, kann aber. Für Dünnschichten ist es unter Umständen von Vorteil, wenn das Substrat während der Beschichtung exzentrisch gedreht wurde. Der Mittelpunkt des Substrats ruht dann nicht, und es kommt in diesem Bereich nicht zu unerwünschten Materialanhäufung.

In den Unteransprüchen 2 bis 5 werden die Lagermaterialien spezifiziert, die sich in den Prozessbedingungen bewähren. Generell eignet als sich als hochwärmefestes, sehr schlecht die Wärme leitendes, dielektrisches Material Oxidkeramik bewährt (Anspruch 2), wie keramisches Al₂O₃ (Anspruch 3), das beispielsweise unter dem Handelsnamen Degussit A124 vertrieben wird, oder Saphir als einkristallines Al₂O₃ (Anspruch 4). Es ist aber auch glasartiges Material, also SiO₂ wie Quarzglas geeignet (Anspruch 5). Weiter kommt als Oxidkeramik ZrO₂ in Betracht (Anspruch 6).

Das Schneckenrad hat an seiner inneren Mantelwand eine umlaufende, trapezförmige Nut, an deren Boden die beiden Lagerrollen abrollen. Beide Lagerrollen sind wenig dicker, als der Boden der Nut breit ist. Damit gibt es kein Verklemmen oder Fressen der beiden Lagerrollen in der trapezförmigen Nut (Anspruch 7).

Generell sind die nichtkeramischen Bauteile der Lagerung aus wärmefestem Edelstahl (Normbezeichnung 1.4301) (Anspruch 7), insbesondere aber aus hochwärmefestem Edelstahl (Normbezeichnungl.4571) zumindest das Schneckenrad, weil dasselbe beim Prozess durch zwei Temperaturzonen läuft (Anspruch 8). Es soll für Langzeitbetrieb geeignet sein und darf daher bei der hohen Prozesstemperatur im nahen Substratbereich von 800 - 900°C nicht verzundern.

Mit der Lagerung des Schneckenrads wird ein einwandfreies ungestörtes Drehen erreicht, Aussetzen, Blockieren und Entkoppeln tritt bei keiner der vorgesehenen Prozesstemperaturen auf. Thermische Ausdehnung ist zulässig und wird, ohne den Beschichtungsprozess zu beeinträchtigen, neutralisiert.

Dadurch, dass das Substrat nur an einer Einspannstelle fest gegriffen wird, sonst aber nur geführt wird, kann es zu keinen thermischen Spannungen in ihm und dem Schneckenrad kommen. Ausschuss durch Substratbruch wegen thermischer Spannungen unterbleibt.

Ein in der Zeichnung dargestelltes Ausführungsbeispiel wird im folgenden näher beschrieben.

Die Zeichnung besteht aus den Figuren 1 bis 3. Es zeigt:
Figur 1 die Lagerung aus Drehachsensicht,
Figur 2 die Lagerung von der Seite,
Figur 3 der Substrathalter aus Drehachsen sicht.

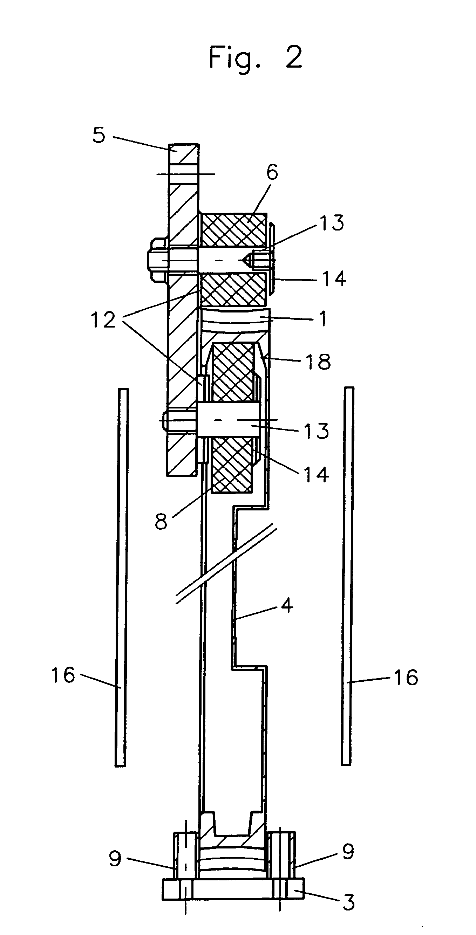

Die Lagerung des Schneckenrads 1 mit Substrathalter 15 wird in einer Multiprozessanlage, dem "Lindwurm", eingesetzt. In ihr ist das Heizsystem in Form zweier spiegelbildlich zueinander stehenden rechteckigen Heizschalen 16, die ein entlang der Spiegelebene durchgehbares quaderförmiges Heizvolumen bilden(siehe DE 100 37 566), installiert. Dort wird eine Temperatur von etwa 800°C eingestellt. Das Substrat 4 dreht sich in dem Heizvolumen in der Spiegelebene exzentrisch oder zentrisch. In Figur 2 ist sie durch die Heizfläche 16 aus INCONEL angedeutet, hat also rechteckige Form, ihre Länge ist größer als der Schneckenraddurchmesser, jedoch ihre Breite erheblich kleiner als derselbe. Beispielsweise wird ein solches Material unter dem Handelsnamen INCONELL 600 vertrieben und hat die Normbezeichnung 2.4816. Der zentrische Kreis in der Heizfläche 16 deutet den Substratdurchmesser an und damit auch den Durchbruch in den beiden Heizflächen 16 durch die hindurch bei beidseitiger Beschichtung der Materialstrom für die Substratbeschichtung fließt. Die Quellen für den Materialstrom können Zylinderkathoden/-kathoden oder Plasmaquellen oder sonstige physikalische Verdampfungsquellen (PVD) sein. Materialfreisetzung durch Laserablation ist ebenfalls zur Bildung des Materialstroms geeignet.

Der Rahmen der Lagerung besteht aus Profilmaterial aus wärmebeständigem Edelstahl, normbezeichnet mit 1.4301, aus hier rechteckigem Querschnitt. Die Hubstange 11 und der Trägerrahmen 3, die übrigen drei Schenkel, sind rechteckig zusammengebaut, geschraubt oder geschweißt. Von der Hubstange 11 hängen die beiden Lagerböcke 5, an der sie fest angebracht sind, herunter. Im Endbereich sitzt je eine Lagerrolle/-scheibe 8 aus Degussit A124, die dort auf einer edelmetallischen, am jeweiligen Lagerbock 5 eingeschraubten Achse (siehe Figur 2) drehend gleitet. Das Schneckenrad 1 aus hochwärmebeständigem Edelstahl der Norm 1.4571 liegt mit seiner hier symmetrisch trapezförmigen Innennut 18 hängend auf den beiden Lagerrollen/-scheiben 8. Die Lagerrollen 8 sind in bekannter Technik gegen Fressen mittels Befestigungsscheibe 14 und Unterlagsscheibe 12 lokalisiert (siehe Figur 2). Außerhalb des Schneckenrads 1 sitzen die beiden Gegenlager 6, je eines an einem Lagerbock 5, und hindern das Schneckenrad 1 am Rausspringen. Die beiden Gegenlager 6 sind wie die beiden Lager 8 aufgebaut auf den das Schneckenrad 1 abrollt, sie berühren das Schneckenrad 1 nicht notwendigerweise. Können oder könnten aber auf dem um den Umfang des Schneckenrads 1 vorhandenen Zahnkranz abrollen, wenn Berührung zustande kommt.

Am der Hubstange 11 gegenüberliegenden Rahmenteil sitzt mittig zu den beiden Lagerscheiben/-rollen 8 das Rollenlager9. Es besteht aus den beiden senkrecht stehenden Lagerhülsen 9 aus Degussit AL24, die gleitfähig auf je einer in dem Trägerrahmen 3 eingeschraubten Achse aus Edelstahl der Norm 1. 4301 stecken. Zwischen beiden Hülsen 9 läuft das Schneckenrad 1 hindurch und wird so mit allenfalls wenig Spiel geführt, somit ist die Substratebene geführt.

An der Hubstange 11 zwischen den beiden Lagerböcken sind die beiden Hülsenlager 7 aus Degussit A124 für die reinragende Antriebsstange 10 aus Edelstahl 1.4571, in ihnen dreht dieselbe gleitend. Die beiden Hülsen 7 sitzen in den beiden kleinen Lagerböcken, die an der Hubstange 11 runterhängen. Zwischen beiden kleinen Lagerböcken sitzt die Schnecke 2 so, dass sie im höchstliegenden Bereich des Schneckenrads 1 eingreift. Die Schnecke 2 selber ist ebenfalls aus Edelstahl der hochwärmebeständigen Norm 1. 4571. In Figur 2 ist der Schneckenantrieb nicht mehr eingezeichnet, er geht aus Figur 1 deutlich und klar hervor.

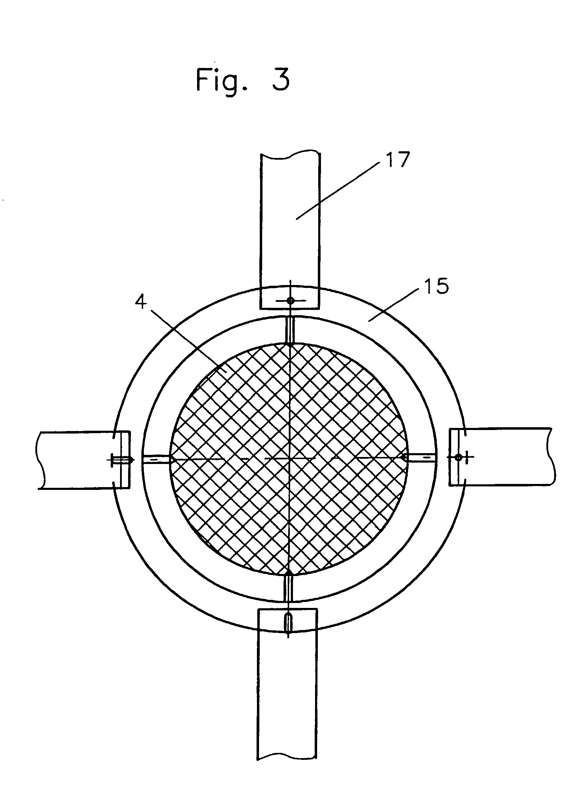

In Figur 1 ist der Substrathalter 15 nur angedeutet. Die eingespannte Situation des Substrats ist in Figur 3 dargestellt. Der Substrathalter 15 wird von den hier vier im Kreis gleichverteilten Haltearmen 17 gehalten, die am Schneckenrad 1 fest verankert sind. Der kreisscheibenförmige Substrathalter 15 ist am freien Ende an demin der Figur oberen Haltearm 17 über den Haltefinger fest eingespannt, an den übrigen ist radiale Ausdehnung und Kontraktion möglich. Das wird durch die dortigen Langlöcher angedeutet, in der sich der jeweilige Haltefinger radial bewegen kann. Die Haltearme 17, Haltefinger und der Substrathalter 15 sind ebenfalls aus hochtemperaturfestem Edelstahl der Norm 1.4571.

Der tagelange Betrieb mit einer solchermaßen aufgebauten Lagerung des Substrathalterads 1 und der darin verankerten Substrathalterung 15 verlief störungsfrei. Die Qualität der auf dem jeweiligen Substrat aufgebrachten Schicht bzw. der beiden Schichten dies- und jenseits war wie erwartet und vorgegeben, wie sich durch ortsaufgelöste Vermessung zeigte.

### Bezugszeichenliste:

- 1: Schneckenrad, Substrathalterad
- 2: Schnecke
- 3: Trägerrahmen
- 4: Substrat
- 5: Lagerbock
- 6: Gegenlager
- 7: 7Lager
- 8: Lagerscheibe
- 9: Rollenlager, Lagerhülse
- 10: Antrieb
- 11: Hubstange
- 12: Distanzscheibe, Unterlagsscheibe
- 13: Gewindebolzen
- 14: Befestigungsscheiben
- 15: Substrathalter
- 16: Heizflächen
- 17: Haltearme
- 18: Nut, Innennut

## Patentansprüche

1. Lagerung eines Substrathalterrades mit darin eingebautem/verankertem Substrathalter in einer Anlage zur Beschichtung eines zumindest einseitig beheizbaren Substrats,
das Substrathalterrad ein Schneckenrad (1) ist, das über eine am Umfangsbereich eingreifende Schnecke (2) angetrieben wird,
die am Ende einer Antriebsstange (10) sitzende Schnecke (2) in einem Lager aus zwei kleinen Lagerböcken (5) zwischen diesen als Antrieb für da Schneckenrad (1) über zwei Gleitlagerhülsen (7) aus hochwärmefestem, dielektrischen Material geführt ist,
der Substrathalter (15) über wenigstens drei am Schneckenrad (1) befestigte, radial nach innen ragende Haltearme (17), an einem davon unverrückbar und an den übrigen radial beweglich, eingespannt ist,
**dadurch gekennzeichnet, dass**:
an einer Hubstange (11) ein Trägerrahmen (3) hängend festgemacht ist und zwei an der Hubstange (11) hängend befestigte, fluchtende Lagerböcke (5), die in den von der Hubstange (11) und dem Trägerrahmen (3) umspannten Innenbereich ragen, auf Abstand zueinander stehen,
je zwei Lagerscheiben (8) aus hochwärmefestem, dielektrischem Material im Endbereich der beiden Lagerböcke (5) drehbar gelagert sind, die sich in einer gemeinsamen Drehebene drehen,
zwei Gegenlagerrollen (6) aus hochwärmefestem, dielektrischen Material, je eine an einem der beiden Lagerböcke (5) oberhalb und in vorgegebenem Abstand zu der jeweilig darunter sitzenden Lagerscheibe (8) befestigt sind, die in der gleichen Drehebene drehen,
ein Rollenlager (9) aus zwei zylindrischen Lagerrollen (9) aus hochwärmefestem, dielektrischen Material im Bodenteil des Trägerrahmens mittig zu den beiden Lagerscheiben (8) sitzt, die Lagerrollen (9) stehend im Bodenteil des Trägerrahmens (3) drehbar gelagert sind sowie dies- und jenseits unter Abstand von mindestens der Dicke des Schneckenrades (1) sitzen, zwischen denen das auf den beiden Lagerscheiben (8) eingelegte Schneckenrad (1) hängend und geführt durchläuft,
die Schnecke (2) bei jeder Prozesstemperatur stets spielend in den Zahnkranz des eingehängten Schneckenrads (1) eingreift.

2. Lagerung eines Substrathalterrads mit Substrathalter nach Anspruch 1,
**dadurch gekennzeichnet,**
**dass** das hochwärmefeste, dielektrische Material Oxidkeramik ist.

3. Lagerung eines Schneckenrades mit Substrathalter nach Anspruch 2,
**dadurch gekennzeichnet,**
**dass** das hochwärmefeste, dielektrische Material keramisches Al₂O₃ ist.

4. Lagerung eines Schneckenrades mit Substrathalter nach Anspruch 2,
**dadurch gekennzeichnet,**
**dass** das hochwärmefeste, dielektrische Material kristallines Al₂O₃, Saphir, ist.

5. Lagerung eines Schneckenrades mit Substrathalter nach Anspruch 2,
**dadurch gekennzeichnet,**
**dass** das hochwärmefeste, dielektrische Material SiO₂, Quarzglas, ist.

6. Lagerung eines Schneckenrades mit Substrathalter nach Anspruch 2,
**dadurch gekennzeichnet,**
**dass** das hochwärmefeste, dielektrische Material ZrO₂ ist.

7. Lagerung eines Schneckenrades mit Substrathalter nach einem der Ansprüche 1 bis 6,
**dadurch gekennzeichnet,**
**dass** das Schneckenrad (1) an der innenliegenden Mantelwand eine umlaufende, trapezförmige Nut (18) hat, an deren Boden die beiden Lagerscheiben (8) abrollen.

8. Lagerung eines Schneckenrades mit Substrathalter nach Anspruch 7,
**dadurch gekennzeichnet,**
**dass** die nichtkeramischen Teile aus wärmefestem Edelstahl sind.

9. Lagerung eines Schneckenrades mit Substrathalter nach Anspruch 8,
**dadurch gekennzeichnet,**
**dass** zumindest das Schneckenrad (1) samt Substrathalter (15) aus hochwärmefestem Edelstahl ist.

## Claims

1. Bearing of a substrate holder wheel with an incorporated/anchored substrate holder in a facility for coating a substrate that can be heated on one side at least,
with the substrate holder wheel being a worm wheel (1) driven by a worm (2) engaging at the circumference,
with the worm (2) at the end of a driving rod (10) being guided in a bearing of two small bearing blocks (5) and arranged between these bearing blocks to drive the worm wheel (2) via two sliding bearing bushes (7) made of a highly temperature-resistant dielectric material,
with the substrate holder (15) being attached immovably to one and in a radially movable manner to the remaining holding arms, with these three holding arms (17) at least being fixed to the worm wheel (1) and protruding radially to the inside,
**characterized by**:
a carrier frame (3) and two aligned bearing blocks (5) being suspended from the lifting rod (11), with these bearing blocks protruding into the inner area enclosed by the lifting rod (11) and the carrier frame (3) at a certain distance from each other,
two bearing disks each (8) made of a highly temperature-resistant, dielectric material being pivoted at the end of both bearing blocks (5) and rotating on a common rotation plane,
two counter-bearing rolls (6) made of a highly temperature-resistant, dielectric material, with one of the rolls each being fixed at the top of one of both bearing blocks (5) and at a given distance from the respective bearing disk (8) below, with both rolls rotating on the same rotation plane,
a roller bearing (9) of two cylindrical bearing rolls (9) made of a highly temperature-resistant, dielectric material being pivoted at the bottom of the carrier frame (3) in the center between both bearing disks (8) and located on both sides of the worm wheel at a distance corresponding to the thickness of the worm wheel (1) at least, with the worm wheel (1) inserted on the two bearing disks (8) being suspended and guided between the rolls,
and with the worm (2) engaging with a certain clearance in the toothed ring of the suspended worm wheel (1) at any process temperature.

2. Bearing of a substrate holder wheel with a substrate holder according to Claim 1, **characterized by** the highly temperature-resistant, dielectric material being oxide ceramics.

3. Bearing of a worm wheel with a substrate holder according to Claim 2, **characterized by** the highly temperature-resistant, dielectric material being ceramic Al₂O₃.

4. Bearing of a worm wheel with a substrate holder according to Claim 2, **characterized by** the highly temperature-resistant, dielectric material being crystalline Al₂O₃, sapphire.

5. Bearing of a worm wheel with a substrate holder according to Claim 2, **characterized by** the highly temperature-resistant, dielectric material being SiO₂, quartz glass.

6. Bearing of a worm wheel with a substrate holder according to Claim 2, **characterized by** the highly temperature-resistant, dielectric material being ZrO₂.

7. Bearing of a worm wheel with a substrate holder according to one of Claims 1 to 6, **characterized by** the worm wheel (1) being provided with a continuous, trapezoidal groove (18) on the inner wall of the casing, with both bearing disks (8) rolling at the bottom of the groove.

8. Bearing of a worm wheel with a substrate holder according to Claim 7, **characterized by** the non-ceramic parts being made of heat-resistant stainless steel.

9. Bearing of a worm wheel with a substrate holder according to Claim 8, **characterized by** the worm wheel (1) and substrate holder (15) at least being made of a highly temperature-resistant stainless steel.

## Revendications

1. Logement d'une roue de support de substrat, avec support de substrat monté (ancré) dans celui-ci, dans une installation de revêtement d'un substrat chauffable du moins sur une face,
la roue de support de substrat étant une roue-vis (1) entraînée par une vis (2) s'engrenant dans la partie circonférentielle,
la vis (2) placée à l'extrémité d'une tige de commande (10) étant conduite dans un palier à deux supports de palier (5) entre ceux-ci, comme mécanisme de commande de la route-vis (1), à travers deux coussinets lisses (7) en matériau superréfractaire diélectrique,
le support de substrat (15) étant serré à travers au moins trois bras supports (17) fixés sur le bord de la vis, dépassant radialement vers l'intérieur, le serrage de l'un d'eux étant inamovible, celui des autres état déplaçable radialement,
**caractérisé en ce que** :
sur une tige (11) est suspendu un cadre porteur (3) et que deux supports de palier (5) suspendus à la tige (11) et alignés qui dépassent dans la zone intérieure enserrée par la tige (11) et le cadre porteur (3) sont écartés l'un de l'autre,
deux disques de palier (8) en matériau superréfractaire diélectrique sont logés de manière orientable dans chacune des parties extrêmes des deux supports de palier (5), qui se tournent dans un plan de rotation commun,
deux rouleaux de palier-support (6) en matériau superréfractaire diélectrique sont fixés chacun sur l'un des deux supports de palier (5), au dessus et à une distance définie du disque de palier (8) situé en dessous, qui tournent dans le même plan de rotation,
un palier à rouleaux (9) constitué de deux rouleaux cylindriques (9) en un matériau superréfractaire diélectrique est placé dans le fond du cadre porteur, axialement par rapport aux deux disques de palier (8), que les rouleaux de palier (9) sont logés verticalement et de manière orientable dans le fond du cadre porteur (3) et se trouvent des deux côtés de celui-ci, à une distance au moins égale à l'épaisseur de la roue-vis (1), entre lesquels passe la roue-vis (1) de manière suspendue et guidée,
à n'importe quelle température opératoire, la vis (2) s'engrène toujours avec jeu dans la couronne dentée de la roue-vis (1) accrochée.

2. Logement d'une roue de support de substrat selon la revendication 1,
**caractérisé en ce que**
le matériau superréfractaire diélectrique est de la céramique oxydée.

3. Logement d'une roue-vis à support de substrat selon la revendication 2,
**Caractérisé en ce que**
Le matériau superréfractaire diélectrique est du Al₂O₃ céramique.

4. Logement d'une roue-vis à support de substrat selon la revendication 2,
**caractérisé en ce que**
le matériaux superréfractaire diélectrique est du Al₂O₃ cristallin, du saphir.

5. Logement d'une roue-vis à support de substrat selon la revendication 2,
**caractérisé en ce que**
le matériau superréfractaire diélectrique est du SiO₂, du verre de quartz.

6. Logement d'une roue-vis à support de substrat selon la revendication 2,
**caractérisé en ce que**
le matériau superréfractaire diélectrique est du ZrO₂.

7. Logement d'une roue-vis à support de substrat selon l'une quelconque des revendications 1 à 6,
**caractérisé en ce que**
la roue-vis (1) dispose sur la paroi de chemise intérieure d'une rainure trapézoïdale (18) circonférentielle, sur le fond de laquelle roulent les deux disques de palier (8).

8. Logement d'une roue-vis à support de substrat selon la revendication 7,
**caractérisé en ce que**
les parties non céramiques sont en acier spécial réfractaire.

9. Logement d'une roue-vis à support de substrat selon la revendication 8,
**caractérisé en ce que**
du moins la roue-vis (1) ainsi que son support de substrat (15) sont en acier spécial réfractaire.
